# EUROPEAN PATENT APPLICATION

(11) **EP 4 734 370 A1**
(43) Date of publication of application: **29.04.2026**
(21) Application number: 24209191.6
(22) Date of filing: 28.10.2024
(51) Int. Cl.: H03K 17/0412, H02M 1/00, H03K 17/16

(54) **DRIVER CHIP AND METHOD FOR DRIVING A GATE OF A POWER TRANSISTOR**

(71) Applicant: Infineon Technologies Austria AG, 9500 Villach (AT)
(72) Inventor: AGARWAL, Vishal, 9500 Villach (AT); FERIANZ, Thomas, 9551 Bodensdorf (AT)
(74) Representative: Lambsdorff & Lange Patentanwälte Partnerschaft mbB

(57) **Abstract**

A driver chip configured to drive a gate of a power transistor comprises: a charger part configured to charge a gate of a power transistor, a logic part configured to control the charger part, a feedback loop configured to connect the gate of the power transistor to the logic part, wherein the logic part is configured to determine, using the feedback loop, a time interval it takes for charging a gate voltage up to a predetermined voltage, wherein the driver chip is configured to control a slew rate of a drain-source voltage of the power transistor using a closed-loop control scheme, and wherein the time interval is a feedback parameter of the closed-loop control scheme.

## Description

### TECHNICAL FIELD

The present disclosure relates to a driver chip, in particular a driver chip configured to perform a closed loop control scheme to drive a gate of a power transistor, as well as to a method for driving a gate of a power transistor.

### BACKGROUND

A power electronic appliance like for example a power converter may have to control the slew rate of the switching node, i.e. the power transistor, in order to balance switching losses on the one hand and electromagnetic interference (EMI) on the other hand. Herein, the "slew rate" is the rate of change of the drain-source voltage of the power transistor, i.e. dV/dt. Higher slew rates can reduce switching losses but cause increased radiated EMI and slower slew rates reduce EMI but lead to increased switching losses. The optimal or preferred slew rate may be application and design dependent. Furthermore, different slew rate control techniques are known. One such technique is closed loop control, wherein a drain-source voltage of the power transistor is monitored, e.g. via a capacitive coupling and this feedback information is used to control the slew rate to conform to the preferred value. However, the commutation time for applications using such a closed loop control scheme is in the order of several microseconds, whereas for many other applications the desired commutation time is in the order of nanoseconds. Employing closed loop control at such small commutation times while monitoring the drain-source voltage which may be in the order of e.g. 600V or more is challenging and comparatively costly. Improved driver chips as well as improved methods for driving a gate of a power transistor may help with solving these and other problems.

### SUMMARY

Certain aspects pertain to a driver chip configured to drive a gate of a power transistor, the driver chip comprising: a charger part configured to charge a gate of a power transistor, a logic part configured to control the charger part, a feedback loop configured to connect the gate of the power transistor to the logic part, wherein the logic part is configured to determine, using the feedback loop, a time interval it takes for charging a gate voltage up to a predetermined voltage, wherein the driver chip is configured to control a slew rate of a drain-source voltage of the power transistor using a closed-loop control scheme, and wherein the time interval is a feedback parameter of the closed-loop control scheme.

Certain aspects pertain to a method for driving a gate of a power transistor, the method comprising: charging a gate of a power transistor with a charger part, controlling the charger part with a logic part, connecting the gate of the power transistor to the logic part via a feedback loop, determining in the logic part, using information provided by the feedback loop, a time interval it takes for charging a gate voltage up to a predetermined voltage, and controlling a slew rate of a drain-source voltage of the power transistor in a closed-loop control scheme, wherein the time interval is a feedback parameter of the closed-loop control scheme.

Those skilled in the art will recognize additional features and advantages upon reading the following detailed description, and upon viewing the accompanying drawings.

### BRIEF DESCRIPTION OF THE DRAWINGS

The present disclosure is illustrated by way of example, and not by way of limitation, in the figures of the accompanying drawings in which like reference numerals refer to similar or identical elements. The elements of the drawings are not necessarily to scale relative to each other. The features of the various illustrated examples can be combined unless they exclude each other.
Fig. 1 illustrates a driver chip for driving a power transistor, wherein the driver chip comprises a feedback loop configured to be connected to a gate node of the power transistor.
Fig. 2 illustrates a further driver chip, similar to the driver chip of Fig. 1, wherein the feedback loop comprises a comparator configured to compare the gate voltage against a predetermined voltage.
Fig. 3 illustrates a further driver chip, similar to the driver chip of Fig. 2, wherein a logic part of the driver chip comprises a reference interval provider part, wherein the logic part is configured to compare a time interval determined using the comparator against a reference time interval.
Fig. 4 illustrates the gate-source voltage of an exemplary GaN power transistor as a function of gate charge.
Fig. 5 illustrates a correlation between a slew rate of a power transistor and a time interval it takes for the gate-source voltage to reach a predefined value, according to an example.
Fig. 6 illustrates the time relation between a PWM signal generated by a charger part of a driver chip, the gate-source voltage of a power transistor and the voltage signal detected by the comparator of the driver chip.
Figs. 7A and 7B illustrate driver chips for driving a power transistor, according to further examples.
Fig. 8 is a flow chart of an exemplary method for driving a gate of a power transistor, wherein the method may for example be performed using any of the driver chips disclosed herein.

### DETAILED DESCRIPTION

In the following detailed description, known structures and elements are shown in schematic form in order to facilitate describing one or more aspects of the disclosure. In this regard, directional terminology, such as "top", "bottom", "left", "right", "upper", "lower" etc., is used with reference to the orientation of the Figure(s) being described. Because components of the disclosure can be positioned in a number of different orientations, the directional terminology is used for purposes of illustration only. It is to be understood that other examples may be utilized and structural or logical changes may be made.

In addition, while a particular feature or aspect of an example may be disclosed with respect to only one of several implementations, such feature or aspect may be combined with one or more other features or aspects of the other implementations as may be desired and advantageous for any given or particular application, unless specifically noted otherwise or unless technically restricted. Furthermore, to the extent that the terms "include", "have", "with" or other variants thereof are used in either the detailed description or the claims, such terms are intended to be inclusive in a manner similar to the term "comprise". The terms "coupled" and "connected", along with derivatives thereof may be used. It should be understood that these terms may be used to indicate that two elements cooperate or interact with each other regardless whether they are in direct physical or electrical contact, or they are not in direct contact with each other; intervening elements or layers may be provided between the "bonded", "attached", or "connected" elements. However, it is also possible that the "bonded", "attached", or "connected" elements are in direct contact with each other. Also, the term "exemplary" is merely meant as an example, rather than the best or optimal.

A driver chip may be manufactured from specific semiconductor material, for example Si. A power transistor chip may for example be manufactured from a semiconductor material like Si, SiC, SiGe, GaAs, GaN, or from any other suitable semiconductor material. A driver chip and a power transistor chip may for example be part of a common power electronic appliance, for example a converter or an inverter. Furthermore, such an appliance may comprise a plurality of driver chips as well as a plurality of power transistor chips which may be electrically connected to form any suitable electrical circuit.

An efficient driver chip and an efficient method for driving a gate of a power transistor may for example reduce material consumption, ohmic losses, chemical waste, etc. and may thus enable energy and/or resource savings. Improved methods and devices, as specified in this description, may thus at least indirectly contribute to green technology solutions, i.e. climate-friendly solutions providing a mitigation of energy and/or resource use.

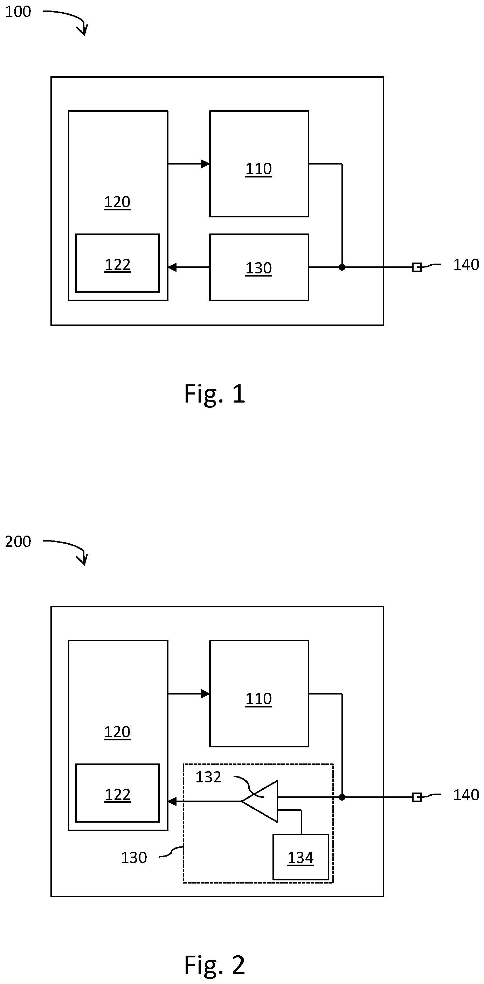

Figure 1 shows a driver chip 100 configured to drive a gate of a power transistor. The driver chip 100 comprises a charger part 110, a logic part 120 and a feedback loop 130. According to an example, the charger part 110 comprises or consists of a controllable current source. According to another example, the charger part 110 comprises or consists of a controlled switch with variable resistance. The driver chip 100 may also comprise further components not shown in Fig. 1. For example, the driver chip 100 may comprise an input configured to be connected to a supply voltage. The supply voltage may for example be V_{DD}.

The driver chip 100 may be configured to drive any suitable power transistor. For example, the driver chip 100 may be configured to drive a GaN power transistor or a high electron mobility transistor (HEMT). The driver chip 100 may for example be configured for use in motor drive applications or household applications. However, the driver chip 100 may also be configured for use in any other suitable application. According to an example, the driver chip 100 comprises or consists of a Si chip.

The driver chip 100 may furthermore comprise an external contact 140 configured to be connected to a gate node of a power transistor. Such a power transistor may for example be comprised in a power transistor chip and the external contact 140 may be configured to be connected to the power transistor chip. The driver chip 100 may furthermore comprise additional external contacts, for example contacts configured to be connected to a drain node or a source node of the power transistor.

The charger part 110 is configured to charge the gate of the power transistor. The charger part 110 may be configured to generate a pulse width modulated (PWM) signal to charge the gate of the power transistor. The PWM signal may have any suitable duty cycle and any suitable strength.

The logic part 120 is configured to control the charger part 110. The logic part 120 may in particular be configured to control the strength of the charger part 110. The logic part 120 may be configured to apply a closed loop control scheme to control the power transistor, wherein the feedback loop 130 provides a feedback parameter of the closed loop control scheme to the logic part 120. The feedback loop 130 may for example be coupled to a closed loop control part 122 of the logic part 120.

The feedback loop 130 is configured to connect the gate of the power transistor to the logic part 120. The logic part 120, in particular the closed loop control part 122, is configured to determine, using the feedback loop 130, a time interval *τ* it takes for charging a gate voltage up to a predetermined voltage. The time interval *τ* is a feedback parameter of the closed-loop control scheme for controlling the power transistor.

According to an example, the feedback loop 130 may comprise a comparator configure to compare a gate-source voltage of the power transistor against the predetermined voltage. The time interval *τ* may for example be started by the logic part 120 when the PWM signal starts and the time interval *τ* ends when the gate voltage is equal to the predetermined voltage. This time interval *τ* may have a definite correlation with a slew rate of a drain-source voltage of the power transistor (wherein the slew rate is dV/dt of the drain-source voltage).

The above-mentioned correlation between the time interval *τ* and the slew rate may be more clearly defined for some power transistors than for others. For example, the correlation may be particularly well defined for GaN power transistors because for these devices, about two thirds of the total gate charge may be Miller charge. Therefore, the predetermined voltage may for example be chosen to be (slightly) higher than the Miller plateau voltage for the highest current the specific power transistor can handle. In this case, the time interval *τ* essentially corresponds to the charge up time to Miller plateau (plus a comparatively little additional time it takes to charge from the Miller plateau up to the predetermined voltage). The predetermined voltage may have to be chosen to be at least slightly bigger than the highest possible Miller plateau voltage in order to ensure that the Miller plateau is reached.

The driver chip 100 is configured to control the slew rate of the drain-source voltage of the power transistor using a closed-loop control scheme as for example outlined above. The driver chip 100 may in particular be configured to measure the currently used slew rate, to determine if the slew rate differs from a preferred slew rate and to change the slew rate to a new value which should be closer to the preferred slew rate. The steps of measuring the slew rate and adapting the slew rate are repeated until the slew rate corresponds to the preferred value (closed loop control). To this end, the logic part 120 may be configured to perform a control algorithm to adapt the slew rate in the closed-loop control scheme. The control algorithm may for example comprise a successive approximation algorithm for changing the slew rate until it corresponds to the preferred value. Changing the slew rate may for example comprise boosting or lowering a drive strength of the charger part 110, for example by connecting or disconnecting resistors out of a set of resistors of the charger part 110.

The above-described closed-loop control scheme does not require information obtainable from the drain node of the power transistor, for example information about drain voltage. Instead, the feedback loop 130 is configured to be connected to the gate node of the power transistor and to provide information obtainable from the gate node. The feedback loop 130 therefore does not need to monitor a high voltage, neither via a direct coupling nor via a capacitive coupling. This may simplify the design and/or reduce fabrication costs of the driver chip 100, the power transistor and/or system application board. For example, no power consuming buffers or high voltage components may be necessary in the feedback loop 130.

Furthermore, the closed loop control scheme using information obtainable from the gate node instead of the drain node of the power transistor may be suitable for fast commutation times without requiring comparatively high design effort and/or implementation effort. The driver chip 100 may therefore provide a cost benefit compared to other driver chips.

The driver chip 100 may for example be suitable for motor drive applications. In this case, the commutation time of the gate-source voltage is in the order of tens or hundreds of nanoseconds and this can be detected with comparatively low and therefore cheap circuit effort, as outlined above.

Figure 2 shows a further driver chip 200 which may be similar or identical to the driver chip 100, except for the differences described in the following.

In particular, the feedback loop 130 of the driver chip 200 comprises a comparator 132. The comparator 132 is configured to compare the gate-source voltage of a power transistor connected to the driver chip 200 against the predetermined voltage, as outlined above. To this end, the feedback loop 130 may comprise a reference voltage generator 134 configured to output the predetermined voltage and to provide the predetermined voltage to an input of the comparator 132. A second input of the comparator 132 is configured to be connected to the gate node of the power transistor, e.g. via the external contact 140. An output of the comparator 132 is coupled to the closed loop control part 122 of the logic part 120 and provides the result of the comparison between the two input voltages to the closed loop control part 122. The closed loop control part 122 may be configured to determine the time interval *τ* by detecting how long it takes from starting to charge the gate of the power transistor to reaching the predetermined voltage.

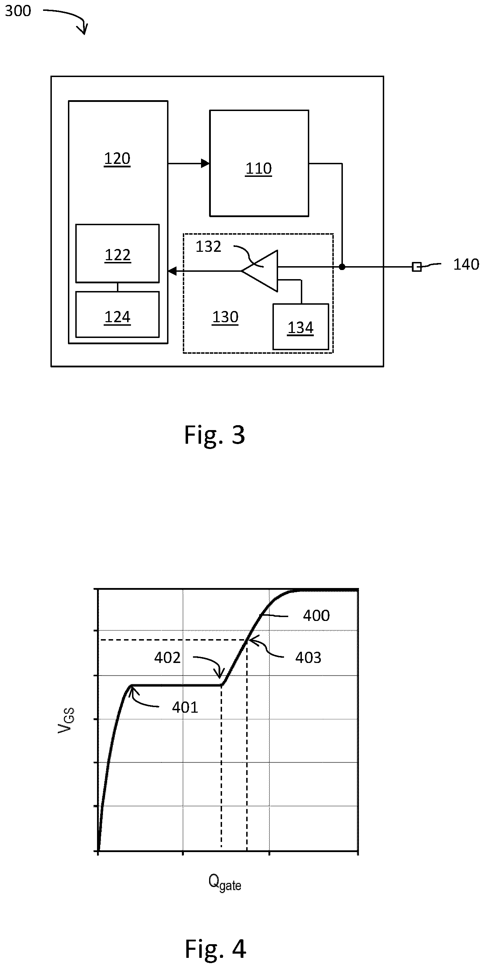

Figure 3 shows a further driver chip 300 which may be similar or identical to the driver chip 100 or 200, except for the differences described in the following. According to an example, the driver chip 300 comprises all components disclosed with respect to the driver chips 100 and 200.

The driver chip 300 additionally comprises a reference interval provider part 124 configured to provide a reference time interval *τ_{ref}* to the closed loop control part 122. The reference time interval *τ_{ref}* provided by the reference interval provider part 124 may be a time interval which corresponds to a preferred or ideal slew rate of the power transistor. The closed loop control part 122 may be configured to determine if and how the measured time interval *τ* differs from the reference time interval *τ_{ref}* and to control the charger part to adapt the slew rate until the measured time interval *τ* is equal to the reference time interval *τ_{ref},* and therefore the actual slew rate is equal to the preferred or ideal slew rate.

Note that the preferred or ideal slew rate may depend on the specific use case of the power transistor. For example, the preferred slew rate may depend on the load connected to the power transistor, wherein the preferred slew rate for a comparatively higher load may be different from a preferred slew rate for a comparatively lower load. According to an example, the reference interval provider part 124 may therefore provide a different reference time intervals *τ_{ref}* depending on the use case.

According to an example, the reference interval provider part 124 comprises or consists of a memory. The memory may store reference time intervals *τ_{ref}* for different use cases.

Figure 4 shows the gate-source voltage of an exemplary GaN power transistor as a function of gate charge. Such a power transistor may be driven using the driver chips 100 to 300.

As shown in Fig. 4, the gate-source voltage curve 400 has an initial rise up to a point 401 where the Miller plateau is reached. The Miller plateau is left at point 402 and the gate-source curve 400 has a further rise. The gate-source voltage curve 400 shown in Fig. 4 may for example be for a GaN power transistor with a particular drain-source current flowing through the power transistor. In the case that a different drain-source current is flowing through the power transistor, the gate-source voltage curve 400 may be shifted. For example, for a smaller drain-source current, the level of the Miller plateau may be lower and for a higher drain-source current, the level of the Miller plateau may be higher. The predetermined voltage which the comparator 132 compares the gate-source voltage against therefore should be chosen to be slightly above the Miller plateau for the highest drain-source current the power transistor is rated for. In the example of Fig. 4, the predetermined voltage may for example be chosen to be at point 403, above the Miller plateau. A GaN power transistor may for example have the Miller plateau at about 1.8V gate-source voltage and the predetermined voltage in this case may for example be at 2.4V.

In particular GaN power transistors may exhibit a comparatively large Miller capacitance which may dominate the charge that has to be delivered to the gate. As noted further above, in GaN power transistors, about two thirds of the required gate charge to reach essentially zero volts drain-source voltage may be Miller charge, compare Fig. 4. Consequently, in these power transistors two thirds of the measured time interval *τ* correspond to charging the Miller capacitance and therefore there is a strong correlation between the measured time interval *τ* and the slew rate of the drain-source voltage of the power transistor.

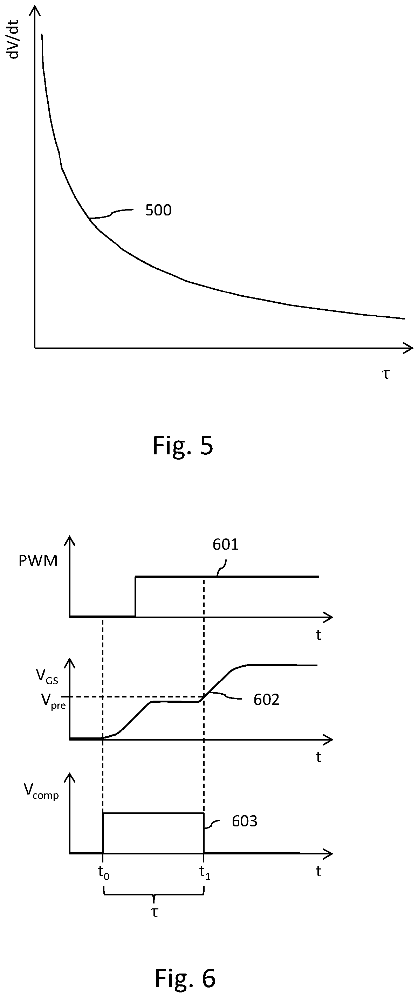

Figure 5 shows an exemplary correlation curve 500 between the slew rate dV/dt and the time interval *τ* of a power transistor. The exemplary correlation curve 500 shows the measured correlation between slew rate and time interval *τ* for a particular GaN power transistor. Other power transistors may have different correlation curves. It may therefore be necessary to establish the correlation between slew rate and time interval *τ* for each different power transistor the driver chips 100 to 300 are to be used with.

As shown in Fig. 5, the correlation between the slew rate and the time interval *τ* is a definite correlation and therefore measuring the time interval *τ* allows unambiguously determining the corresponding slew rate once the correlation is known. According to an example, the logic part 120 of the driver chips 100 to 300 may comprise a memory configured to store values for the time interval *τ* and corresponding values for the slew rate for the particular power transistor the driver chip is driving.

Figure 6 shows the time relation between the PWM signal generated by the charger part 110, the gate-source voltage of the power transistor and the voltage signal detected by the comparator 132, according to an example. In particular, the upper part of Fig. 6 shows the PWM signal, the middle part shows the gate-source voltage and the lower part shows the signal of the comparator 132.

As shown in Fig. 6, at point t₀ the PWM curve 601 starts, i.e. has a rising edge, and the charger part 110 begins to provide charge to the gate of the power transistor. This causes the gate-source voltage curve 602 to rise and this is also the point at which a signal pulse 603 in the comparator 132 starts, i.e. where the time interval *τ* has its starting point. At point t₁ the gate-source voltage has reached the predetermined voltage Vₚᵣₑ which the comparator detects as explained further above and the time interval *τ* ends.

Note that the example shown in Fig. 6 concerns determination of the time interval *τ* and consequently closed loop slew rate control for turn on of the power transistor. In a similar manner, a turn off time interval *τ_{off}* and consequently the turn off slew rate may be determined for the turn off case. In this case, the time interval *τ_{off}* may start at a falling edge of the PWM curve 601 and may end at a second, different predetermined voltage V'ₚᵣₑ which may for example be slightly below the Miller plateau voltage. Furthermore, determining the turn off slew rate may comprise using a second comparator to detect V'ₚᵣₑ.

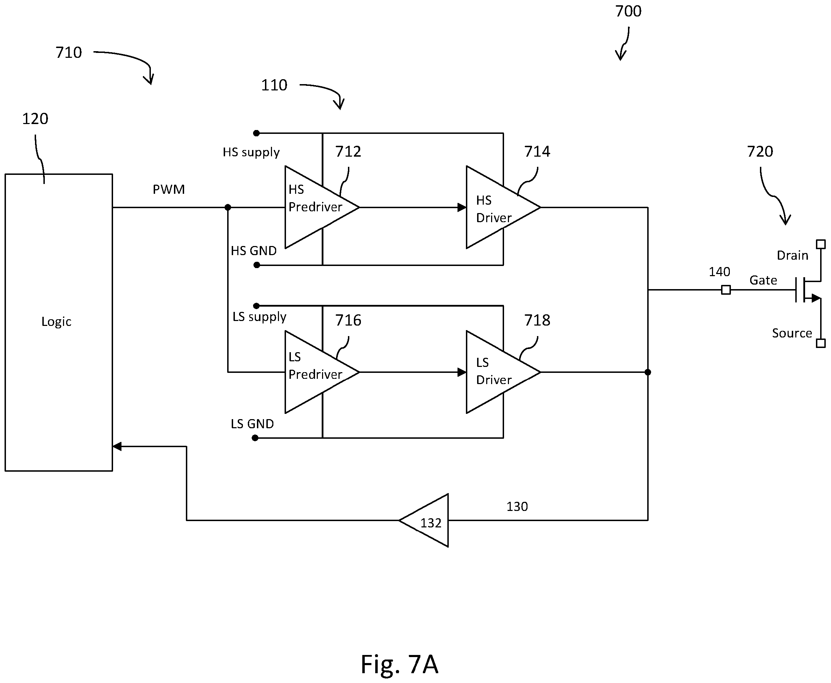

Figure 7A shows a power electronic system 700 comprising a driver chip 710 and a power transistor 720, wherein the driver chip 710 is configured to drive the power transistor 720. The power transistor 720 may for example be comprised in a power transistor chip. The power transistor chip may for example be a GaN chip. The driver chip 710 may for example be similar or identical to the driver chips 100 to 300.

The charger part 110 of the driver chip 710 comprises a high side predriver 712 and a high side driver 714 connected to a high side supply and to high side ground potential. The charger part 110 further comprises a low side predriver 716 and a low side driver 718 connected to a low side supply and to low side ground potential. An output of the high side predriver 712 and the low side predriver 716 are connected to an input of the high side driver 714 and the low side driver 718, respectively. The logic 120 is configured to provide a PWM signal to the high side predriver 712 and to the low side predriver 716 to control the charger part 110. The feedback loop 130 with the comparator connects the gate of the power transistor 720 to the logic part 120 as explained further above.

The comparator 132 is used to determine the time interval *τ* and thereby the turn on slew rate of the power transistor 720 as described further above. The logic part 110 is configured to lower or boost the slew rate by adapting a drive strength of the charger part 110 in order to make the actual slew rate equal to the preferred slew rate. The closed loop control scheme employed by the driver chip 710 may comprise repeating the steps of determining the slew rate and adapting the slew over a few drive cycles.

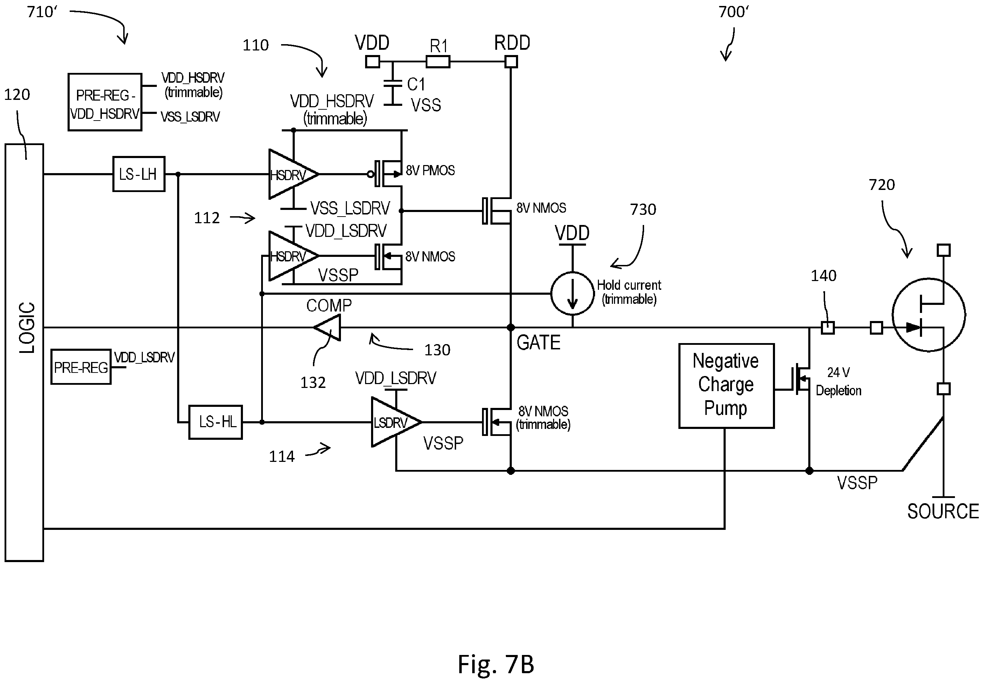

Figure 7B shows a further power electronic system 700' comprising a driver chip 710' and a power transistor 720, wherein the driver chip 710' is configured to drive the power transistor 720. The driver chip 710' may for example be similar or identical to the driver chips 100 to 710, except for the differences described in the following.

According to an example, the charger part 110 of the driver chip 710' comprises a high side driver part 112 and a low side driver part 114 which are controlled by the logic part 120. The high side driver part 112 and the low side driver part 114 are connected to supply voltages VDD_HSDRV, VDD_LSDRV, V_{DD} and V_{SSP}. According to an example, the driver chip 710' is configured to use the information obtained from the feedback loop 130, in particular the comparator 132, for providing a further functionality in addition to closed loop slew rate control: the driver chip 710' may be configured to turn off the charger part 110, e.g. the high side driver part, once the predetermined gate-source voltage is reached. At this point, the driver chip 710' may be configured to switch to providing a constant hold current to the gate of the power transistor 720 using a hold current source 730 which may be trimmable. The hold current may be configured to ensure short circuit protection for the applied drain-source current value.

According to an example, the power electronic system 700 or 700' is a semiconductor package or semiconductor module, wherein the driver chip 710 and the power transistor chip comprising the power transistor 720 are encapsulated in a common encapsulation body. The encapsulation body may for example comprise or consist of a molded body or a plastic frame. According to another example, the driver chip 710 and the power transistor chip are encapsulated in two separate encapsulation bodies.

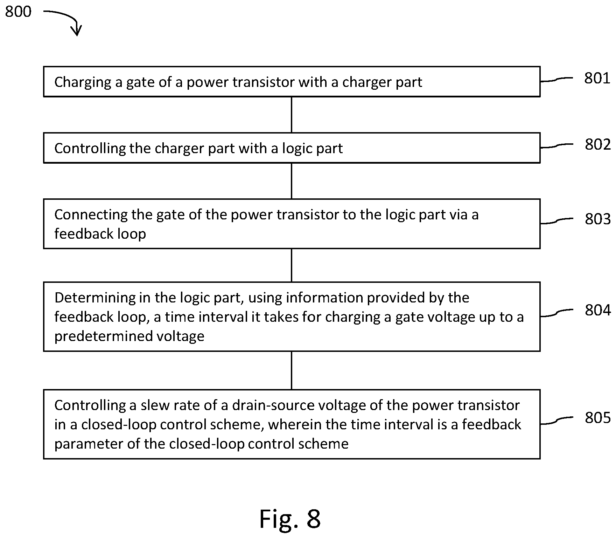

Figure 8 is a flow chart of an exemplary method 800 for driving a gate of a power transistor. The method 800 may for example be performed using any of the driver chips 100 to 710.

The method 800 comprises at 801 a process of charging a gate of a power transistor with a charger part, at 802 a process of controlling the charger part with a logic part, at 803 a process of connecting the gate of the power transistor to the logic part via a feedback loop, at 804 a process of determining in the logic part, using information provided by the feedback loop, a time interval it takes for charging a gate voltage up to a predetermined voltage, and at 805 a process of controlling a slew rate of a drain-source voltage of the power transistor in a closed-loop control scheme, wherein the time interval is a feedback parameter of the closed-loop control scheme.

According to an example, the method 800 further comprises comparing the gate voltage against the predetermined voltage using a comparator of the feedback loop. According to an example, the method 800 further comprises a process of using a control algorithm in the logic part to adapt the slew rate in the closed-loop control scheme. This may in particular comprise a process of determining, with the logic part, if the slew rate is higher or lower than an ideal or preferred slew rate, and a process of adapting a drive strength of the charger part in order to lower or boost the slew rate until the slew rate equals the ideal or preferred slew rate.

### EXAMPLES

In the following, the driver chip and the method for driving a gate of a power transistor are further explained using specific examples.

Example 1 is a driver chip configured to drive a gate of a power transistor, the driver chip comprising: a charger part configured to charge a gate of a power transistor, a logic part configured to control the charger part, a feedback loop configured to connect the gate of the power transistor to the logic part, wherein the logic part is configured to determine, using the feedback loop, a time interval it takes for charging a gate voltage up to a predetermined voltage, wherein the driver chip is configured to control a slew rate of a drain-source voltage of the power transistor using a closed-loop control scheme, and wherein the time interval is a feedback parameter of the closed-loop control scheme.

Example 2 is the driver chip of example 1, wherein the feedback loop comprises a comparator.

Example 3 is the driver chip of example 2, wherein the comparator is configured to compare the gate voltage against the predetermined voltage.

Example 4 is the driver chip of example 3, wherein the predetermined voltage is higher than a Miller plateau voltage.

Example 5 is the driver chip of one of examples 2 to 4, wherein the current source is configured to generate a pulse width modulated signal to charge the gate of the power transistor, and wherein the time interval starts at an edge of the pulse width modulated signal.

Example 6 is the driver chip of example 5, wherein the time interval ends when the gate voltage is equal to the predetermined voltage.

Example 7 is the driver chip of one of the preceding examples, wherein the logic part is configured to perform a control algorithm to adapt the slew rate in the closed-loop control scheme.

Example 8 is the driver chip of example 7, wherein the logic part is configured to determine if the slew rate is higher or lower than an ideal slew rate and wherein the control algorithm adapts a drive strength of the charger part in order to lower or boost the slew rate until the slew rate equals the ideal slew rate.

Example 9 is the driver chip of one of the preceding examples, wherein the driver chip is free of any feedback connections configured for monitoring a drain voltage of the power transistor.

Example 10 is the driver chip of one of the preceding examples, wherein the charger part comprises a high side predriver, a high side driver connected to an output of the high side predriver, a low side predriver and a low side driver connected to an output of the low side predriver, wherein the driver chip is configured to have the gate of the power transistor coupled between an output of the high side driver and an output of the low side driver.

Example 11 is a method for driving a gate of a power transistor, the method comprising: charging a gate of a power transistor with a charger part, controlling the charger part with a logic part, connecting the gate of the power transistor to the logic part via a feedback loop, determining in the logic part, using information provided by the feedback loop, a time interval it takes for charging a gate voltage up to a predetermined voltage, and controlling a slew rate of a drain-source voltage of the power transistor in a closed-loop control scheme, wherein the time interval is a feedback parameter of the closed-loop control scheme.

Example 12 is the method of example 11, wherein the feedback loop comprises a comparator.

Example 13 is the method of example 12, further comprising: comparing the gate voltage against the predetermined voltage using the comparator.

Example 14 is the method of example 13, wherein the predetermined voltage is higher than a Miller plateau voltage.

Example 15 is the method of one of examples 11 to 14, further comprising: using a control algorithm in the logic part to adapt the slew rate in the closed-loop control scheme.

Example 16 is the method of example 15, further comprising: determining, with the logic part, if the slew rate is higher or lower than an ideal slew rate, and adapting a drive strength of the charger part in order to lower or boost the slew rate until the slew rate equals the ideal slew rate.

Example 17 is an apparatus comprising means for performing the method according to anyone of examples 11 to 16.

Although specific examples have been illustrated and described herein, it will be appreciated by those of ordinary skill in the art that a variety of alternate and/or equivalent implementations may be substituted for the specific examples shown and described without departing from the scope of the present invention. This application is intended to cover any adaptations or variations of the specific examples discussed herein. Therefore, it is intended that this invention be limited only by the claims and the equivalents thereof.

It should be noted that the methods and devices including its preferred embodiments as outlined in the present document may be used stand-alone or in combination with the other methods and devices disclosed in this document. In addition, the features outlined in the context of a device are also applicable to a corresponding method, and vice versa. Furthermore, all aspects of the methods and devices outlined in the present document may be arbitrarily combined. In particular, the features of the claims may be combined with one another in an arbitrary manner.

It should be noted that the description and drawings merely illustrate the principles of the proposed methods and systems. Those skilled in the art will be able to implement various arrangements that, although not explicitly described or shown herein, embody the principles of the invention and are included within its spirit and scope. Furthermore, all examples and embodiments outlined in the present document are principally intended expressly to be only for explanatory purposes to help the reader in understanding the principles of the proposed methods and systems. Furthermore, all statements herein providing principles, aspects, and embodiments of the invention, as well as specific examples thereof, are intended to encompass equivalents thereof.

## Claims

1. A driver chip (100) configured to drive a gate of a power transistor, the driver chip (100) comprising:
a charger part (110) configured to charge a gate of a power transistor,
a logic part (120) configured to control the charger part (110),
a feedback loop (130) configured to connect the gate of the power transistor to the logic part (120),
wherein the logic part (120) is configured to determine, using the feedback loop (130), a time interval it takes for charging a gate voltage up to a predetermined voltage,
wherein the driver chip (100) is configured to control a slew rate of a drain-source voltage of the power transistor using a closed-loop control scheme, and
wherein the time interval is a feedback parameter of the closed-loop control scheme.

2. The driver chip (100) of claim 1, wherein the feedback loop (130) comprises a comparator (132).

3. The driver chip (100) of claim 2, wherein the comparator (132) is configured to compare the gate voltage against the predetermined voltage.

4. The driver chip (100) of claim 3, wherein the predetermined voltage is higher than a Miller plateau voltage.

5. The driver chip (100) of one of claims 2 to 4, wherein the charger part (110) is configured to generate a pulse width modulated signal to charge the gate of the power transistor, and
wherein the time interval starts at an edge of the pulse width modulated signal.

6. The driver chip (100) of claim 5, wherein the time interval ends when the gate voltage is equal to the predetermined voltage.

7. The driver chip (100) of one of the preceding claims, wherein the logic part (120) is configured to perform a control algorithm to adapt the slew rate in the closed-loop control scheme.

8. The driver chip (100) of claim 7, wherein the logic part (120) is configured to determine if the slew rate is higher or lower than an ideal slew rate and wherein the control algorithm adapts a drive strength of the charger part (110) in order to lower or boost the slew rate until the slew rate equals the ideal slew rate.

9. The driver chip (100) of one of the preceding claims, wherein the driver chip (100) is free of any feedback connections configured for monitoring a drain voltage of the power transistor.

10. The driver chip (710) of one of the preceding claims, wherein the charger part (110) comprises a high side predriver 712, a high side driver 714 connected to an output of the high side predriver 712, a low side predriver 716 and a low side driver 718 connected to an output of the low side predriver 716,
wherein the driver chip (710) is configured to have the gate of the power transistor coupled between an output of the high side driver 714 and an output of the low side driver 716.

11. A method (800) for driving a gate of a power transistor, the method (800) comprising:
charging (801) a gate of a power transistor with a charger part,
controlling (802) the charger part with a logic part,
connecting (803) the gate of the power transistor to the logic part via a feedback loop,
determining (804) in the logic part, using information provided by the feedback loop, a time interval it takes for charging a gate voltage up to a predetermined voltage, and
controlling (805) a slew rate of a drain-source voltage of the power transistor in a closed-loop control scheme,
wherein the time interval is a feedback parameter of the closed-loop control scheme.

12. The method (800) of claim 11, wherein the feedback loop comprises a comparator.

13. The method (800) of claim 12, further comprising:
comparing the gate voltage against the predetermined voltage using the comparator.

14. The method (800) of claim 13, wherein the predetermined voltage is higher than a Miller plateau voltage.

15. The method (800) of one of claims 11 to 14, further comprising:
using a control algorithm in the logic part to adapt the slew rate in the closed-loop control scheme,
determining, with the logic part, if the slew rate is higher or lower than an ideal slew rate, and
adapting a drive strength of the charger part in order to lower or boost the slew rate until the slew rate equals the ideal slew rate.
